# FASCICULE DE BREVET EUROPEEN

(11) **EP 3 066 688 B1**
(45) Date de publication et mention de la délivrance du brevet: **01.04.2020**
(21) Numéro de dépôt: 14799366.1
(22) Date de dépôt: 04.11.2014
(51) Int. Cl.: H01L 27/146, H01L 33/38

(54) **DETECTEUR NUMERIQUE POSSEDANT UN GENERATEUR DE LUMIERE PERMETTANT UN EFFACEMENT OPTIQUE**
DIGITALDETEKTOR MIT LICHTGENERATOR ZUR AKTIVIERUNG VON OPTISCHEM LÖSCHEN
DIGITAL DETECTOR POSSESSING A GENERATOR OF LIGHT ENABLING OPTICAL WIPING

(30) Priorité: 04.11.2013 FR 1360763
(43) Date de publication de la demande: 14.09.2016
(73) Titulaire: Trixell, 38430 Moirans (FR)
(72) Inventeur: RACINE, Benoit, 38430 Moirans (FR); NEYRET, Robert, 38500 Coublevie (FR); COMMERE, Bruno, 38120 Saint-Egreve (FR)
(74) Mandataire: Collet, Alain
(86) Numéro de dépôt international: PCT/EP2014/073650
(87) Numéro de publication internationale: WO 2015/063314

(56) Documents cités:
- EP-A1- 2 528 113
- WO-A1-2007/086485
- DE-A1- 19 743 523
- US-A1- 2008 308 739
- US-A1- 2012 126 124

## Description

La présente invention concerne un détecteur de rayonnement X à l'état solide comportant un capteur photosensible pouvant être associé à un convertisseur de rayonnement. Les domaines d'application de ce type de détecteur sont notamment la radiologie : radiographie, fluoroscopie, mammographie, mais également le contrôle non destructif.

De tels détecteurs de rayonnement sont par exemple décrits dans le brevet français FR 2 803 081 dans lequel un capteur formé de photodiodes en silicium amorphe est associé à un convertisseur de rayonnement. Des détecteurs de rayonnement sont également décrits dans US2012/126124A1 et EP2528113A1.

Le fonctionnement et la structure d'un tel détecteur de rayonnement vont être rappelés succinctement.

Le capteur photosensible est généralement réalisé à partir d'éléments photosensibles à l'état solide arrangés en matrice. Les éléments photosensibles sont réalisés à partir de matériaux semi-conducteurs, le plus souvent du silicium mono cristallin pour les capteurs de type CCD ou CMOS, du silicium poly cristallin ou amorphe. Un élément photosensible comporte au moins une photodiode, un phototransistor ou une photo résistance. Ces éléments sont déposés sur un substrat, généralement une dalle de verre.

Ces éléments ne sont généralement pas sensibles directement aux rayonnements de longueurs d'ondes très courtes comme le sont les rayons X ou gamma. C'est pourquoi, on associe le capteur photosensible à un convertisseur de rayonnement qui comporte une couche d'une substance scintillatrice. Cette substance a la propriété, lorsqu'elle est excitée par de tels rayonnements, d'émettre un rayonnement de longueur d'onde supérieure, par exemple de la lumière visible ou proche du visible, auquel est sensible le capteur. La lumière émise par le convertisseur de rayonnement illumine les éléments photosensibles du capteur qui effectuent une conversion photoélectrique et délivrent des signaux électriques exploitables par des circuits appropriés. Le convertisseur de rayonnement sera appelé scintillateur dans la suite de la description.

Pour améliorer la qualité d'une image utile, on effectue une correction de l'image utile à partir d'une image dite d'offset connue sous la dénomination française d'image noire généralement prise et stockée en début d'un cycle de fonctionnement. Cette image d'offset est l'image obtenue alors que le dispositif photosensible est exposé à un signal d'intensité nulle et correspond à une sorte d'image de fond. L'image d'offset varie en fonction de l'état électrique des composants des éléments photosensibles et de la dispersion de leurs caractéristiques électriques. L'image utile est celle lue alors que le dispositif photosensible a été exposé à un signal utile qui correspond à une exposition à un rayonnement X. Elle englobe l'image d'offset. La correction consiste à effectuer une soustraction entre l'image utile et l'image d'offset.

Pour réaliser une image utile ou une image d'offset on réalise un cycle d'images, c'est à dire une suite formée par une phase de prise d'image suivie d'une phase de lecture puis d'une phase d'effacement et de réinitialisation comme expliqué dans la demande de brevet FR-A-2 760 585. Durant la phase de prise d'image, les éléments photosensibles sont exposés à un signal à capter que ce signal soit un éclairement maximum ou l'obscurité. Durant la phase de lecture une impulsion de lecture est appliquée aux conducteurs ligne adressés pour lire la quantité de charges accumulée lors de la prise d'image. Durant la phase d'effacement les éléments photosensibles sont effacés optiquement au moyen d'un flash de lumière uniformément réparti sur l'ensemble des points photosensibles. Durant la phase de réinitialisation, les éléments photosensibles sont remis dans un état dans lequel ils sont réceptifs à une nouvelle prise d'image. Cette remise en état s'effectue en rendant temporairement un élément interrupteur, diode de commutation ou transistor, conducteur au moyen d'une impulsion électrique envoyée sur des conducteurs ligne permettant l'adressage de la matrice.

A ce jour le flash de lumière est obtenu au moyen d'un générateur de lumière formé d'une matrice de diodes électroluminescentes placée sur la face arrière du détecteur. Par convention, on appelle face avant du détecteur la face exposée au rayonnement X et face arrière la face opposée à la face avant. Lors du flash de lumière, la matrice de diodes électroluminescentes émet un rayonnement visible qui traverse la dalle de verre formant le substrat du capteur photosensible puis se réfléchit sur des faces situées en amont du capteur photosensible 13 avant d'atteindre les éléments photosensibles. On peut également réaliser le générateur de lumière au moyen de lampes toujours placées sur la face arrière du détecteur.

Dans certaines applications en imagerie médicale où le détecteur est en mouvement durant un examen, comme par exemple en tomodensitométrie, une lame d'air présente entre le générateur de lumière et le détecteur peut voir son épaisseur évoluer avec les mouvements du détecteur. La variation de cette lame d'air peut entrainer la formation d'une image fantôme du générateur de lumière sur les images issues du détecteur. Cette image fantôme est connue dans la littérature anglo-saxonne sous le nom de « Grid Effect ».

Un autre inconvénient des générateurs de lumière réalisés au moyen de diodes électroluminescentes ou de lampes réside dans l'épaisseur de tels générateurs.

On a également tenté de placer en face arrière du détecteur une couche de diodes électroluminescentes organiques appelées par la suite OLED en référence à leur dénomination anglo-saxonne : « Organic Light-Emitting Diode ». Ce type de diode réalisée sous forme d'une couche de matériau luminescent disposé entre deux électrodes dont une au moins est transparente pour permettre l'émission de lumière hors de la couche. Pour les OLED, Il est connu d'utiliser une électrode transparente réalisée en oxyde d'indium dopé à l'étain appelé par la suite ITO en référence à sa dénomination anglo-saxonne : « Indium tin oxide ». Ce type d'électrode est particulièrement adapté pour des couches d'OLED de petites surfaces. En effet, on s'est rendu compte que l'ITO présente une résistivité importante. Pour une couche d'OLED de grande surface, la luminosité n'est pas homogène. L'éclairement est plus important sur les bords qu'au centre de la couche. Les détecteurs de rayonnement X sont obligatoirement de grande dimension puisqu'il est pratiquement impossible de focaliser ce type de rayonnement du fait de son énergie élevée. Dans la radiologie médicale, on a réalisé des détecteurs numériques dont les dimensions sont semblables à celles des films argentiques utilisés par le passé. On trouve couramment des détecteurs dont les dimensions dépassent 400 mm de coté. Pour de telles dimensions, une couche d'OLED possédant une électrode d'ITO ne permettrait pas d'être utilisée pour réaliser un flash de lumière homogène.

L'invention vise à pallier tout ou partie des problèmes cités plus haut en proposant un détecteur numérique de rayonnement à l'état solide dans lequel un flash de lumière uniformément réparti permet la réinitialisation des pixels. L'invention présente un intérêt important pour un détecteur de rayonnement X. Il est néanmoins possible de mettre en œuvre l'invention pour d'autres types de rayonnements comme par exemple les rayonnements gamma.

A cet effet, l'invention a pour objet un détecteur numérique à l'état solide d'un rayonnement incident selon la revendication 1.

L'invention sera mieux comprise et d'autres avantages apparaîtront à la lecture de la description détaillée de différents modes de réalisation donnés à titre d'exemple, description illustrée par le dessin joint dans lequel :
les figures 1a, 1b et 1c représentent schématiquement en coupe plusieurs configurations d'un détecteur numérique selon l'invention ;
la figure 2a représente schématiquement en coupe un exemple de générateur de lumière 14 appartenant un détecteur numérique selon l'invention ;
la figure 2b représente en perspective une électrode et des conducteurs électriques supplémentaires du générateur de lumière 14 ;
la figure 3 représente schématiquement en coupe agrandie un détecteur dans la configuration de la figure 1b ;
la figure 4 représente schématiquement en coupe agrandie un détecteur dans la configuration de la figure 1a ;
la figure 5 illustre un exemple de répartition de conducteurs électriques supplémentaires du détecteur ;
la figure 6 représente schématiquement en coupe agrandie une variante du détecteur dans la configuration de la figure 1b.

Par souci de clarté, les échelles ne sont pas respectées. De plus, les mêmes éléments porteront les mêmes repères dans les différentes figures.

Un détecteur numérique 10 à l'état solide selon l'invention permet de former une image fonction d'un rayonnement incident auquel il est sensible comme par exemple un rayonnement X 11. Le détecteur 10 comprend un scintillateur 12 permettant de convertir le rayonnement X 11 en rayonnement visible, un capteur photosensible 13 permettant de convertir le rayonnement visible issu du scintillateur 12 en signaux électriques formant l'image et un générateur de lumière 14 destiné à effacer optiquement les éléments photosensibles du capteur 13. Il est bien entendu que le détecteur 10 peut comprendre d'autres composants. L'invention peut être mise en œuvre dans un détecteur numérique sans scintillateur et dont le capteur effectue une conversion directe du rayonnement 11 en signal électrique. A cet effet, le capteur photosensible 13 comprend un photoconducteur directement sensible au rayonnement incident.

Plus précisément, lors du fonctionnement du détecteur 10, pour obtenir une image, on réalise une suite d'opérations formée d'une phase de prise d'image pendant laquelle le détecteur 10 est soumis au rayonnement X, suivie d'une phase de lecture au cours de laquelle on lit les signaux électriques issus de chacun des éléments photosensibles puis d'une phase d'effacement optique au cours de laquelle on éclaire l'ensemble des éléments photosensibles de façon uniforme et enfin une phase de réinitialisation électrique de l'ensemble des points photosensibles.

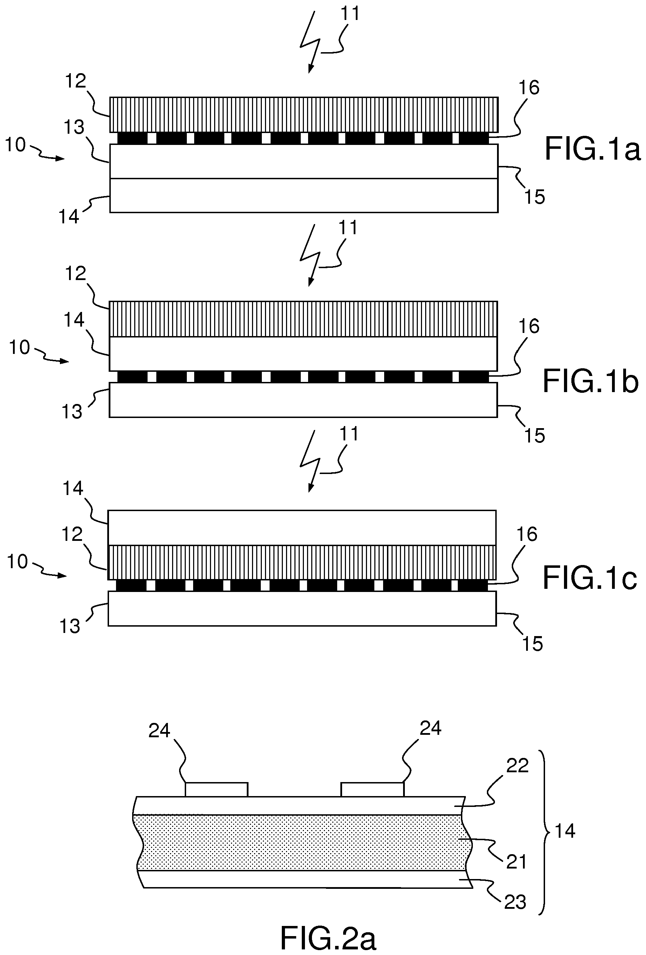

Les figures 1a, 1b et 1c permettent d'illustrer trois configurations dans lesquelles l'invention peut être mise en œuvre. Par convention, on définit la face avant du détecteur 10 comme la face recevant en premier le rayonnement X, la face arrière étant opposée à la face avant. On définit également les positions relatives des différents composants du détecteur entre eux par rapport au sens de propagation du rayonnement X. On dira par exemple que le scintillateur 12 est situé en amont du capteur photosensible 13 car le scintillateur 12 reçoit le rayonnement X avant le capteur photosensible 13. Dans la pratique, le capteur 13, ne reçoit que très peu de rayonnement X, car le rayonnement X est en quasi-totalité converti en rayonnement visible par le scintillateur 12. La notion d'amont et d'aval peut également s'entendre pour le sens de propagation du rayonnement visible que le scintillateur 12 émet en direction du capteur 13.

Sur la figure 1a, on trouve de l'amont vers l'aval : le scintillateur 12, le capteur 13 et le générateur de lumière 14. Autrement dit, le générateur de lumière 14 est situé sur la face arrière du détecteur 10. Le capteur photosensible 13 comprend un substrat 15 et des éléments photosensibles 16. Dans cette configuration, le flash de lumière émis par le générateur 14 pour l'effacement optique des points photosensibles 16 traverse le substrat 15, passe entre les éléments photosensibles 16 et se réfléchit sur des faces situées en amont du capteur photosensible 13 avant d'atteindre les éléments photosensibles 16 par leur face amont. Plus précisément, le flash de lumière peut se réfléchir sur un substrat du scintillateur 12 et/ou à l'interface entre le scintillateur 12 et le capteur photosensible 13 sur des faces ou se produit une rupture d'indice optique. Le substrat 15 doit être transparent à la lumière émise par le générateur 14. C'est le cas, lorsqu'on utilise une dalle de verre pour réaliser le substrat 15. Autrement dit, le capteur photosensible 13 comprend un substrat 15 sur lequel sont disposés les éléments photosensibles 16. Le générateur de lumière 14 est disposé en aval du substrat 15. Le substrat 15 est apte à être traversé par de la lumière émise par le générateur de lumière 14.

Ce trajet du flash de lumière est compliqué et une partie seulement de la lumière émise par le générateur 14 est réellement utilisée pour l'effacement optique des éléments photosensibles 16. La lumière émise et atteignant directement les éléments photosensibles 16 par leur face arrière ne contribue pas à l'effacement du fait de l'opacité des éléments photosensibles 16. Dans cette configuration, la fraction de lumière atteignant les éléments photosensibles 16 est faible et correspond à l'absence de matière dans un pixel. De plus, avant d'arriver sur l'élément photosensible 16, la lumière doit se réfléchir sur des faces situées en amont du capteur photosensible 13 ce qui engendre une perte supplémentaire. Il est courant d'obtenir de l'ordre de 10 % de lumière utile. La part de lumière perdue doit être compensée par une augmentation de l'intensité lumineuse et donc une augmentation de la consommation électrique du générateur de lumière 14. Néanmoins cette configuration peut être utile car elle permet de ne pas placer le générateur de lumière 14 en amont des éléments photosensibles 16.

Sur la figure 1b, on trouve de l'amont vers l'aval : le scintillateur 12, le générateur de lumière 14 et le capteur 13. Autrement dit, le générateur de lumière 14 est situé entre le scintillateur 12 et le capteur photosensible 13. Cette configuration permet d'utiliser la totalité de la lumière émise par le générateur 14 pour l'effacement optique soit par un trajet direct entre le générateur 14 et les éléments photosensibles 16 soit après réflexion de la lumière émise par le générateur 15 sur le scintillateur 12. Pour un même résultat, dans la configuration de la figure 1b, il est possible de réduire très nettement l'intensité lumineuse du générateur 14 par rapport à la configuration de la figure 1a. Cette réduction permet de réduire la consommation électrique du générateur de lumière 14. En revanche, la présence du générateur 14 entre le scintillateur 12 et le capteur 13 éloigne le scintillateur 12 du capteur 13 ce qui peut nuire à la qualité de limage issue du détecteur 10 ainsi configuré. Cet inconvénient est néanmoins modéré du fait de la faible épaisseur du générateur de lumière 14. Le gain en consommation électrique contribue à un gain en épaisseur du générateur de lumière 14.

Les figures 1a et 1b peuvent également illustrer un détecteur de rayonnement sans scintillateur dont le capteur photosensible 13 est directement sensible au rayonnement incident. Il suffit pour cela d'ôter le scintillateur des figures 1a et 1b. Le capteur photosensible 13 comprend alors un photoconducteur directement sensible au rayonnement incident 11.

Sur la figure 1c, on trouve de l'amont vers l'aval : le générateur de lumière 14, le scintillateur 12, et le capteur 13. Autrement dit, le générateur de lumière 14 est situé en amont du scintillateur 12. Dans cette configuration le scintillateur 12 absorbe une partie de la lumière émise par le générateur 14. Une partie de la lumière émise par le générateur de lumière 14 est perdue comme dans la configuration de la figure 1a. La configuration de la figure 1c présente néanmoins l'intérêt d'une meilleure homogénéité de la lumière reçue par le capteur 13. En effet, la lumière reçue n'est pas gênée par les éléments photosensibles 16. Du fait de cette bonne homogénéité, la configuration de la figure 1c permet d'utiliser le générateur 14 pour d'autres utilisations comme par exemple pour réaliser une calibration des pixels.

En comparant les configurations des figures 1b et 1c, en plaçant le générateur de lumière 14 entre le scintillateur 12 et le capteur 13, le générateur de lumière 14 n'interagit pas avec le rayonnement X puisqu'absorbé par le scintillateur 12. On risque moins un vieillissement prématuré du générateur de lumière 14, vieillissement pouvant se produire dans la configuration de la figure 1c où le rayonnement X traverse le générateur de lumière 14.

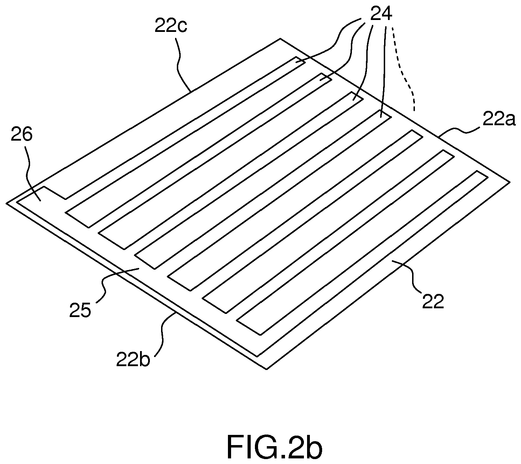

La figure 2 représente en coupe un exemple de générateur de lumière 14 selon l'invention. Le générateur de lumière 14 comprend une couche électroluminescente 21. Cette couche est constituée d'un matériau apte à transformer une énergie électrique en lumière. Cette couche est par exemple formée de diode électroluminescente organique 21. A ce jour, plusieurs familles de diodes électroluminescentes organiques sont connues et peuvent être mise en œuvre dans l'invention comme par exemple des diodes électroluminescentes organiques appelée par la suite OLED en référence à leur dénomination anglo-saxonne : « Organic Light-Emitting Diode ». D'autres types de couche peuvent être mise en œuvre comme par exemple une couche de diodes électroluminescentes à polymère connu dans la littérature anglo-saxonne sous le nom de PLED pour « Polymer Light-Emitting Diodes ». Les OLED et les PLED sont des couches organiques. Pour mettre en œuvre l'invention, il n'est pas nécessaire que la couche électroluminescente soit organique. Dans la suite de la description on utilisera le terme d'OLED pour désigner toute couche électroluminescente.

De plus, le générateur 14 comprend une électrode 22 apte à être traversée par la lumière émise par le générateur 14 avant d'atteindre le capteur 13. L'électrode 22 peut être transparente ou translucide. L'électrode 22 est disposée sur une des faces de la couche d'OLED en la recouvrant de façon continue. Une seconde électrode 23 est disposée sur l'autre face de la couche d'OLED. La seconde électrode 23 n'est pas nécessairement apte à être traversée par la lumière émise par le générateur 14 sauf dans le cas de la configuration de la figure 1b pour que la lumière émise par le scintillateur 12 puisse traverser le générateur de lumière 14. Les lumières émises par le générateur de lumière 14 et par le scintillateur ont généralement des longueurs d'ondes voisines situées dans le visible. Les électrodes 22 et 23 sont des conducteurs électriques dans lesquelles les électrons peuvent circuler librement. Les électrodes sont reliées chacune à un potentiel électrique par exemple au moyen d'un plot de connexion. Les électrodes 22 et 23 sont caractérisées par leur conductivité électrique (exprimée en Ω⁻¹) qu'il est possible de mesurer entre deux points distants de l'électrode considérée en appliquant une tension continue et en mesurant le courant circulant. On peut définir une conductivité surfacique d'une électrode rectangulaire en divisant la conductivité mesurée entre deux coins opposés du rectangle par la surface du rectangle.

La couche d'OLED est par exemple réalisée au moyen d'un empilage de plusieurs couches : une couche de transport de trous, une couche d'émission et une couche de transport d'électrons. Les couches de transport sont par exemple formées dans un matériau semi-conducteur. En appliquant une tension électrique entre les électrodes 22 et 23, des électrons et des trous pénètrent dans la couche d'émission. Les électrons et les trous se combinent en émettant des photons sur le principe de la luminescence.

Dans les configurations des figures 1a et 1c, la seconde électrode 23 peut être opaque à la lumière émise par le générateur 14. On peut par exemple utiliser un métal ou un alliage métallique pour la réaliser. Dans la configuration de la figure 1c où le générateur de lumière 14 est disposé en amont du scintillateur 12, la seconde électrode 23 peut par exemple être réalisée en alliage d'aluminium qui possède une bonne transparence au rayonnement X et qui peut assurer également un rôle de fenêtre d'entrée et de scellement du capteur 10. L'alliage d'aluminium peut assurer une bonne étanchéité permettant de protéger le scintillateur 12 de toute agression extérieure. On peut par exemple réaliser le scintillateur 12 en iodure de césium qui est sensible à l'humidité. L'alliage d'aluminium de la seconde électrode 23 peut donc être utilisé pour encapsuler le scintillateur 12 et le protéger de l'humidité.

L'électrode 22 comprend par exemple de l'oxyde d'indium dopé à l'étain bien connu par son acronyme ITO pour son appellation dans la littérature anglo-saxonne : « Indium tin oxide ». Ce matériau est bien connu pour ses propriétés de transparence optique lorsqu'il est mis en œuvre en couche mince. L'ITO possède aussi de bonnes propriétés de conductivité électrique. Néanmoins pour conserver une bonne transparence, il est nécessaire de réduire son épaisseur ce qui dégrade sa conductivité électrique. D'autres oxydes métalliques peuvent être mis en œuvre tel que par exemple l'oxyde de zinc dopé à l'aluminium bien connu par son acronyme AZO pour son appellation dans la littérature anglo-saxonne : « Aluminum-doped zinc oxide ». Pour réaliser une électrode transparente, on peut également mettre en œuvre une couche métallique dont l'épaisseur est de l'ordre du nanomètre ou encore des nanotubes de carbones. Une caractéristique commune à tous ces matériaux, permettant de réaliser l'électrode 22, est qu'ils peuvent conduire les électrons librement, c'est-à-dire de façon passive sans excitation particulière. Ces matériaux ne possèdent pas de bande interdite. Autrement dit, il y a chevauchement entre la bande de valence et la bande de conduction, contrairement aux matériaux semi-conducteurs.

Dans l'utilisation d'un générateur de lumière 14 pour effacer optiquement les éléments photosensibles 16 du capteur 10, sur chaque face de la couche d'OLED 21 est disposée une électrode unique, respectivement 22 et 23, couvrant la totalité de la couche d'OLED 21.

L'alimentation électrique du générateur de lumière 14 se fait par ses bords. Pour un générateur 14 de grande surface, la distance parcourue par le courant dans l'électrode 22 pour alimenter la couche d'OLED 21 est d'autant plus important qu'on s'éloigne des bords du générateur 14. Ceci entraine une baisse de luminosité au centre du générateur 14 par rapport à la luminosité obtenue sur ses bords.

Pour pallier ce problème le générateur de lumière 14 selon l'invention comprend des conducteurs électriques supplémentaires 24 en contact électrique avec l'électrode 22 et formant des branches s'étendant sur la surface de l'électrode 22 Les conducteurs électriques supplémentaires 24 sont répartis spatialement à la surface de l'électrode 22. La conductivité des conducteurs électriques supplémentaires 24 vient s'ajouter à celle de l'électrode 22 améliorant ainsi la conductivité globale de l'ensemble formé par l'électrode 22 et les conducteurs électriques supplémentaires 24.

La figure 2b représente en perspective l'électrode 22 et les conducteurs électriques supplémentaires 24. Les branches formant les conducteurs électriques supplémentaires 24 s'étendent parallèlement les unes aux autres sensiblement entre un bord 22a de l'électrode 22 et un bord opposé 22b. Dans le cas d'une électrode 22 rectangulaire, les branches sont parallèles à un coté 22c du rectangle, le bord 22c étant perpendiculaire aux cotés 22a et 22b. Un conducteur électrique 25 peut relier électriquement les branches 24. Le conducteur 25 est disposé le long du bord 22b et hors de la surface utile du générateur de lumière 14. L'électrode 22 les conducteurs supplémentaires 24 sont reliés à une source de potentiel au moyen d'un plot de connexion 26 disposé dans un coin de l'électrode 22. Alternativement, la fonction de plot de connexion peut être assurée par le conducteur électrique 25.

Avantageusement, la répartition spatiale des conducteurs électriques supplémentaires 24 est faite de façon périodique à la surface de l'électrode 22, ce qui permet d'améliorer l'uniformité de l'éclairement issu du générateur de lumière 14.

La répartition périodique des conducteurs électriques supplémentaires 24 permet d'homogénéiser la luminosité globale du générateur de lumière 14. On obtient entre chaque branche une baisse de luminosité. Les baisses de luminosité sont réparties à la surface du générateur 14. Ces baisses de luminosité sont plus faibles que la baisse de luminosité obtenue en l'absence de conducteurs électriques supplémentaires 24. On choisit le nombre de conducteurs électriques supplémentaires 24, et donc leur espacement, en fonction du niveau d'homogénéité recherchée.

Les conducteurs électriques supplémentaires 24 sont par exemple opaques à la lumière émise par le générateur de lumière 14, ce qui permet d'augmenter le choix de matériaux possibles pour réaliser ces conducteurs. On peut par exemple réaliser les conducteurs électriques supplémentaires 24 en métal ou en alliage métallique ce qui permet d'obtenir une conductivité bien supérieure à celle de l'électrode 22. A titre d'exemple, on peut réaliser les conducteurs supplémentaires en aluminium, en or, en platine ou en alliage de ces métaux. La conductivité des conducteurs opaques 24 devient prépondérante dans la conductivité globale et l'affaiblissement de luminosité n'intervient qu'entre chaque conducteur électrique supplémentaire opaque 24.

En radiologie médicale, il est courant de mettre en œuvre un détecteur de forme carrée de 430mm de coté. Au moyen d'un conducteur électrique supplémentaire 24 métallique de 5 à 10 µm de large ; on peut obtenir une résistance électrique de ce conducteur inférieure à 3kΩ sur sa longueur de 430mm. Des essais réalisés en interne ont montrés qu'au moyen de tels conducteurs supplémentaires, on peut obtenir une homogénéité lumineuse spatiale supérieure à 80%.

Les conducteurs électriques 24, 25 et le plot 26 peuvent être réalisés dans le même matériau.

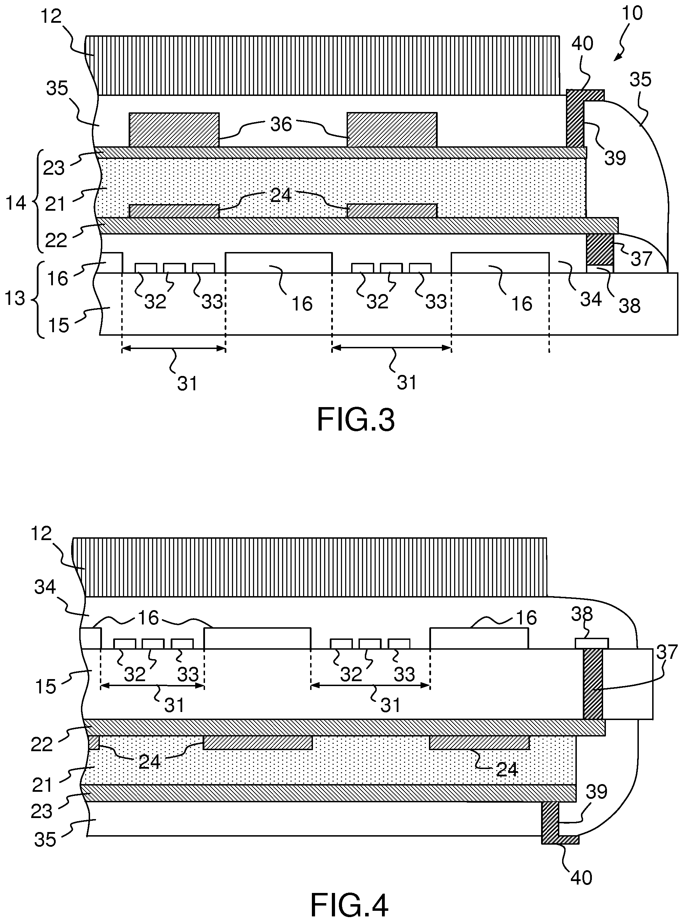

La figure 3 représente en coupe agrandie le détecteur de la configuration de la figure 1b dans laquelle le générateur de lumière 14 est disposé entre le capteur 13 et le scintillateur 12. La structure du générateur de lumière 14 présentée à l'aide de cette configuration peut être appliquée aux autres configurations décrite à l'aide des figures 1a et 1c. Le capteur photosensible 13 comprend des éléments photosensibles 16 organisés en matrice. Sur la figure 3, trois éléments photosensibles 16 apparaissent. Dans la pratique, un capteur photosensible 13 peut comprendre un grand nombre d'éléments photosensibles 16, par exemple de l'ordre du million. Les éléments photosensibles 16 ne recouvrent pas la totalité de la surface du capteur photosensible 13. Des interstices 31 sont formés entre des éléments photosensibles 16 voisins. Des composants 32 peuvent être disposés dans les interstices 31. Les composants 32 permettent le fonctionnement des éléments photosensibles 16. On trouve par exemple un transistor suiveur, un transistor de lecture et un transistor de remise à zéro associés à chacun des éléments photosensibles 16. On désigne par pixel, l'ensemble formé par un élément photosensible et les composants 32 associés. Dans les interstices 31 circulent également des conducteurs électriques 33 permettant d'alimenter, de commander et de lire les différents éléments photosensibles 16 au travers des composants 32.

Pour les configurations décrites à l'aide des figures 1b et 1c, c'est-à-dire lorsque le générateur de lumière 14 est disposé en amont du capteur photosensible 13 dans la direction de propagation du rayonnement 11, les conducteurs électriques supplémentaires 24 sont avantageusement disposés en regard des interstices 31 séparant les éléments photosensibles 16. Les conducteurs électriques supplémentaires 24 peuvent réduire la transmission de la lumière émise par le générateur 14 sans gêner l'efficacité du générateur 14 vis-à-vis des éléments photosensibles 16. Il est même possible de mettre en œuvre des conducteurs électriques supplémentaires 24 opaques sans aucune gêne.

Dans l'exemple représenté sur la figure 3, les conducteurs électriques supplémentaires 24 ne recouvrent pas les éléments photosensibles 16. Alternativement, il est possible d'accepter un recouvrement partiel des éléments photosensibles 16 par les conducteurs électriques supplémentaires 24. Ce recouvrement peut être dû aux dimensions des interstices 31. Ces dimensions ne sont pas obligatoirement constantes sur la périphérie d'un élément photosensible 16. Dans la configuration de la figure 1b, les conducteurs électriques supplémentaires 24 peuvent gêner la transmission de la lumière émise par le scintillateur 12 et le recouvrement partiel nuit à la collecte par les éléments photosensible 16 de la lumière émise par le scintillateur 12. En revanche, ce problème n'existe pas dans les autres configurations des figures 1a et 1c.

Le taux de recouvrement est déterminé en fonction d'un compromis entre l'efficacité du générateur 14 vis-à-vis des éléments photosensibles 16 et l'amélioration de la conductivité électrique de l'ensemble formé par l'électrode 22 et les conducteurs électriques supplémentaires 24.

Dans la configuration de la figure 1b où le générateur de lumière est placé entre le scintillateur 12 et le capteur 13, le générateur de lumière 14 ne possède une transparence totale à la lumière émise par le scintillateur 12 en direction du capteur 13. La présence des conducteurs électriques supplémentaires 24 permet de réduire l'épaisseur de l'électrode 22 améliorant ainsi la transparence du générateur de lumière vis-à-vis de la lumière émise par le scintillateur 12.

La figure 4 représente en coupe agrandie le détecteur de la configuration de la figure 1a dans laquelle le générateur de lumière 14 est disposé sur la face arrière du capteur photosensible 13. Autrement dit, le générateur de lumière 14 est disposé en aval du capteur photosensible 13 dans la direction de propagation du rayonnement 11.

Dans cette configuration, les conducteurs électriques supplémentaires 24 sont avantageusement disposés en regard de zones opaques du capteur photosensible 13. Les zones opaques sont notamment les zones dans lesquelles sont situés les éléments photosensibles 16. Le capteur photosensible 13 possède des zones transparentes, notamment dans les interstices 31 et plus précisément entre les composants 32. Les conducteurs électriques supplémentaires 24 ne gênent pas la transmission de la lumière émise par le générateur de lumière 14 vers les zones transparentes du capteur photosensible 13.

Les éléments photosensibles 16 sont répartis périodiquement à la surface du capteur 14. Avantageusement, la période de répartition des conducteurs électriques supplémentaires 24 est multiple de celle des éléments photosensibles 16. Un conducteur électrique supplémentaire 24 peut être placé en regard de chaque interstice 31 dans la variante de la figure 3 ou de chaque élément photosensible 16 dans la variante de la figure 4. Il est également possible d'espacer les conducteurs électriques supplémentaires 24 et de ne recouvrir qu'un parmi N interstices 31 ou éléments photosensibles 16, N étant un nombre entier supérieur à 1. Ce nombre N est choisi en fonction de l'affaiblissement de luminosité acceptable entre deux conducteurs électriques supplémentaires 24.

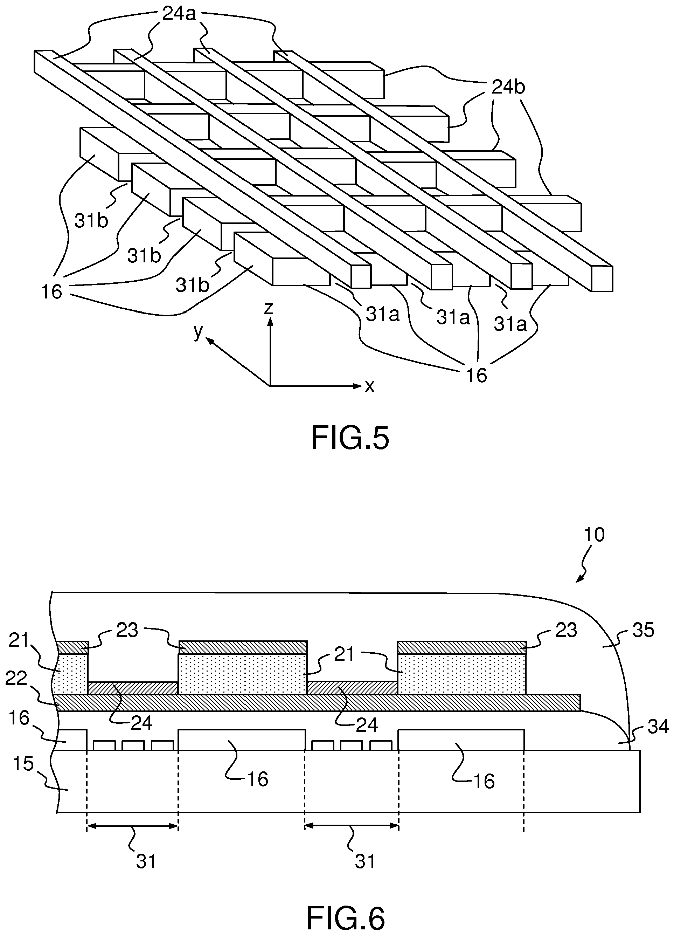

La figure 5 illustre un exemple de répartition de conducteurs électriques supplémentaires 24 en regard des interstices 31. Pour ne pas surcharger la figure, seuls des éléments photosensibles 16 et des conducteurs électriques supplémentaires 24 ont été représentés en perspective. Les éléments photosensibles 16 sont organisés en matrice suivant des directions perpendiculaires x et y. Une direction z est perpendiculaire aux directions x et y. Des interstices 31a séparent les éléments photosensibles 16 suivant la direction x et des interstices 31b séparent les éléments photosensibles 16 suivant la direction y. Des conducteurs électriques supplémentaires 24a sont disposés en regard des interstices 31a et des conducteurs électriques supplémentaires 24b sont disposés en regard des interstices 31b. Autrement dit, les conducteurs électriques supplémentaires 24a ont la même abscisse selon l'axe x que les interstices 31a et les conducteurs électriques supplémentaires 24b ont la même ordonnée selon l'axe y que les interstices 31b. Les indices a et b associés aux interstices et aux conducteurs électriques supplémentaires ne sont présents que pour dissocier les deux directions x et y. Les objets indicés ont bien entendu les mêmes caractéristiques que ceux présentés plus haut sans indice.

Dans l'exemple illustré figure 5, des conducteurs électriques supplémentaires 24a ou b recouvrent tous les interstices 31a ou b. Comme on l'a évoqué plus haut, il est possible de ne disposer des conducteurs électriques supplémentaires que tous les N interstices 31a ou b. On peut disposer des conducteurs électriques supplémentaires 24a tous les N interstices 31a et des conducteurs électriques supplémentaires 24b tous les M interstices 31b avec N différent de M.

Cette répartition croisée des conducteurs supplémentaire est bien entendu transposable dans la variante de la figure 4. Les conducteurs électriques supplémentaires 24a ou b recouvrent alors les éléments photosensibles 16. Autrement dit, les conducteurs électriques supplémentaires comprennent une première série de branches 24a parallèles entre elles et une seconde série de branches 24b parallèles entre elles. La première série 24a et la seconde série 24b se croisent.

Par ailleurs, il est possible de ne disposer des conducteurs électriques supplémentaires que dans une seule des deux directions x ou y.

Le détecteur 10 peut comprendre une couche de passivation 34 disposée entre le capteur photosensible 13 et le générateur de lumière 14. Cette couche est par exemple réalisée en nitrure de silicium. En l'absence de générateur de lumière 14 entre le scintillateur 12 et le capteur 13, il est utile de disposer une couche barrière entre la couche de passivation et le scintillateur afin de protéger le capteur 13 d'éventuels produits de décomposition du scintillateur 12. La présence du générateur de lumière 14 entre le scintillateur 12 et le capteur 13 permet de se passer de cette couche barrière.

Le générateur de lumière 14 est avantageusement encapsulé. En effet, la couche d'OLED 21 doit être isolée de l'atmosphère. En effet, la couche d'OLED 21 se dégrade fortement lorsqu'elle soumise à de l'humidité. L'encapsulation est réalisée au moyen d'une couche 35 recouvrant la seconde électrode 23 et les faces latérales du générateur de lumière 14. L'encapsulation peut être réalisée entre deux lames de verre, ce qui est réalisable dans les configurations des figures 1a et 1c pour lesquelles le générateur de lumière est disposé à l'extérieur d'un ensemble formé par le capteur photosensible 13 et le scintillateur 12. Pour la configuration de la figure 1b où le générateur de lumière est disposé entre le capteur photosensible 13 et le scintillateur 12 on préfère utiliser un film barrière couramment mis en œuvre dans les couches d'OLED.

Il est possible de se passer de la couche de passivation 34 et de réaliser directement le générateur de lumière 14 sur le capteur 13. La couche d'encapsulation 35 recouvre alors le générateur de lumière 14 et les éléments photosensibles 16.

Dans les configurations des figures 1a et 1c, dans lesquelles la lumière émise par le scintillateur 12 ne traverse pas le générateur de lumière 14, la seconde électrode 23 peut être complètement opaque à la lumière visible. Dans ces configurations, on a peu de contrainte d'épaisseur pour l'électrode 23 et on peut utiliser une feuille métallique, par exemple en alliage d'aluminium dont la conductivité électrique est suffisamment bonne sur la totalité de la surface du détecteur 10. Par contre dans la configuration de la figure 1b où la lumière émise par le scintillateur 12 traverse le générateur de lumière 14, la seconde électrode 23 doit avoir un niveau de transparence suffisant. A ce jour, il existe des électrodes métalliques semi transparentes. Leur transparence est de l'ordre de 70%. Il est souhaitable d'améliorer la transparence de cette électrode. On peut le faire en réduisant son épaisseur, mais cette réduction pose le même problème que pour l'électrode 22 de diminution de la conductivité électrique. Alternativement à une électrode métallique semi transparente, il est possible de réaliser la seconde électrode en ITO.

Comme pour l'électrode 22, il est possible d'adjoindre à l'électrode 23 des conducteurs électriques supplémentaires 36 en contact électrique avec l'électrode 23. Comme pour l'électrode 22, les conducteurs électriques supplémentaires 36 sont répartis spatialement de façon périodique à la surface de l'électrode 23. Leur répartition est avantageusement identique à celle des conducteurs électriques supplémentaires 24.

Les conducteurs électriques supplémentaires 24 et 36 peuvent être réalisés en matériau métallique épais, comme par exemple en alliage d'aluminium ou de chrome. Il est possible de disposer les conducteurs électriques supplémentaires 24 et 36 à l'intérieur ou à l'extérieur de la couche d'OLED 21.

Le raccordement électrique des deux électrodes 22 et 23 se fait par les bords du générateur de lumière 14. Dans la configuration de la figure 1b, représenté plus en détail sur la figure 3, l'électrode 22 est située à proximité immédiate du capteur 13. Il est possible d'assurer le raccordement de l'électrode 22 par le substrat 15. Ce substrat porte déjà les éléments photosensibles, les composants 32 et les conducteurs électriques 33. A cet effet, le détecteur 10 comprend un via 37 raccordant l'électrode 22 à un conducteur 38 réalisé sur le substrat. Le via 37 traverse la couche de passivation 34. Ce mode de raccordement peut également être mis en œuvre dans la configuration de la figure 1a représenté plus en détail sur la figure 4 où le générateur de lumière 14 est situé en face arrière du détecteur 10. Dans cette configuration le via 37 traverse le substrat 15. Assurer un raccordement électrique par le substrat 15 permet d'utiliser des moyens de connexion déjà existants et raccordant le capteur 13 vers des circuits de commande et de lecture du détecteur 10 pouvant être disposés sur des substrats distincts du substrat 15.

Le raccordement électrique de l'électrode 23 peut se faire au moyen d'un autre via 39 traversant la couche d'encapsulation 35 pour les figures 3 et 4. Le via 39 raccorde l'électrode 23 et un plot 40 réalisé sur la couche d'encapsulation 35 par exemple au moyen d'un dépôt métallique. Le raccordement du plot 40 aux circuits de commande du détecteur 10 est par exemple réalisé au moyen d'un circuit imprimé souple non représenté.

La couche d'OLED 21 peut être continue sur toute sa surface comme représentée sur les figures 3 et 4. Alternativement, la couche d'OLED 21 peut être discontinue. La couche d'OLED 21 est par exemple interrompue au niveau des conducteurs électriques supplémentaires 24. En effet, ces conducteurs pouvant être opaques ou à tout le moins réduisant la transmission de la lumière les traversant, on peut se passer de matériau luminescent en regard des conducteurs électriques supplémentaires 24. Cela permet d'obtenir une meilleure distribution de la tension électrique appliquée à la couche d'OLED 21 et donc une meilleure uniformité de l'éclairement.

La figure 6 illustre un exemple de réalisation du capteur 10 dans laquelle la couche d'OLED 21 est discontinue. La figure 6 correspond à la configuration des figures 1b et 3. Comme dans la figure 3, l'électrode 22 représentée figure 6 est disposée sur la couche de passivation 34. On rappelle que la couche de passivation 34 est optionnelle. L'électrode 22 est continue et on retrouve les conducteurs électriques supplémentaires 24 disposés en regard des interstices 31 séparant les éléments photosensibles 16. La couche d'OLED 21 est déposée en regard des éléments photosensibles 16 et est interrompue en regard des interstices 31.

L'électrode 23 peut être discontinue comme représenté sur la figure 4 ou encore continue sur toute la surface de la couche d'OLED 21.

Dans les configurations des figures 1b et 1c dans lesquelles le générateur de lumière 14 est disposé en amont du capteur 13, les discontinuités de la couche d'OLED 21 sont disposées en regard des interstices 31 séparant les éléments photosensibles 16. Dans la configuration de la figure 1a où le générateur de lumière 14 est disposé en aval du capteur 13, les discontinuités de la couche d'OLED 21 sont disposées en regard zones opaques du capteur 13 notamment en regard des éléments photosensibles 16.

## Revendications

1. Détecteur numérique à l'état solide d'un rayonnement incident (11), le détecteur (10) comprenant un capteur photosensible (13) comprenant des éléments photosensibles (16) organisés en matrice, un générateur de lumière (14) destiné à effacer optiquement les éléments photosensibles (16), le générateur de lumière (14) comprenant:
• une couche électroluminescente (21) répartie sur la surface du capteur (13),
• au moins une électrode (22, 23) recouvrant de façon continue la couche électroluminescente (21), l'électrode (22, 23) étant un conducteur électrique dans lequel des électrons peuvent circuler librement, l'électrode (22, 23) étant apte à être traversée par de la lumière émise par la couche électroluminescente (21), le générateur de lumière étant **caractérisé en ce qu'**il comprend
des conducteurs électriques supplémentaires (24, 36) en contact électrique avec l'électrode (22, 23), les conducteurs électriques supplémentaires (24, 36) formant des branches s'étendant sur la surface de l'électrode (22, 23), et étant répartis spatialement à la surface de l'électrode (22, 23).

2. Détecteur selon la revendication 1, **caractérisé en ce que** les éléments photosensibles (16) sont répartis périodiquement à la surface du capteur (14).

3. Détecteur selon la revendication 2, **caractérisé en ce que** la répartition des conducteurs électriques supplémentaires (24) est périodique et multiple de celle des éléments photosensibles (16).

4. Détecteur selon l'une des revendications précédentes, **caractérisé en ce que** les conducteurs électriques supplémentaires comprennent une première série de branches (24a) parallèles entre elles et une seconde série de branches (24b) parallèles ente elles et **en ce que** la premières série (24a) et la seconde série (24b) se croisent.

5. Détecteur selon l'une des revendications précédentes, **caractérisé en ce qu'**il comprend un scintillateur (12) convertissant le rayonnement incident étant un premier rayonnement (11) en un second rayonnement auquel le capteur photosensible (13) est sensible.

6. Détecteur selon l'une des revendications 1 à 4, **caractérisé en ce que** le capteur photosensible (13) comprend un photoconducteur directement sensible au rayonnement incident (11).

7. Détecteur selon l'une des revendications précédentes, **caractérisé en ce que** les conducteurs électriques supplémentaires (24) sont opaques à la lumière émise par le générateur de lumière (14).

8. Détecteur selon l'une des revendications précédentes, **caractérisé en ce que** le générateur de lumière (14) est disposé en amont du capteur photosensible (13) dans la direction de propagation du premier rayonnement (11), **en ce que** des interstices (31) sont formés entre des éléments photosensibles (16) voisins et **en ce que** les conducteurs électriques supplémentaires (24) sont disposés en regard d'interstices (31) séparant les éléments photosensibles (16).

9. Détecteur selon la revendication 8, **caractérisé en ce que** les conducteurs électriques supplémentaires (24) ne recouvrent pas les éléments photosensibles (16).

10. Détecteur selon la revendication 5 et l'une quelconque des revendications 8 ou 9, **caractérisé en ce que** le générateur de lumière (14) est disposé entre le scintillateur (12) et le capteur photosensible (13).

11. Détecteur selon la revendication 10, **caractérisé en ce qu'**il comprend une couche de passivation (34) disposée entre le capteur photosensible (13) et le générateur de lumière (14).

12. Détecteur selon la revendication 5 et l'une quelconque des revendications 7 à 9, **caractérisé en ce que** le générateur de lumière (14) est disposé en amont du scintillateur (12) dans la direction de propagation du premier rayonnement (11).

13. Détecteur selon l'une quelconque des revendications 5 à 7, **caractérisé en ce que** le générateur de lumière (14) est disposé en aval du capteur photosensible (13) dans la direction de propagation du premier rayonnement (11).

14. Détecteur selon la revendication 13, **caractérisé en ce que** le capteur photosensible (13) comprend un substrat (15) sur lequel sont disposés les éléments photosensibles (16), **en ce que** le générateur de lumière (14) est disposé en aval du substrat (15) et **en ce que** le substrat (15) est apte à être traversé par de la lumière émise par le générateur de lumière (14).

15. Détecteur selon l'une des revendications précédentes, **caractérisé en ce que** la couche électroluminescente (21) est interrompue au niveau des conducteurs électriques supplémentaires (24, 36).

16. Détecteur selon l'une des revendications précédentes, **caractérisé en ce que** les conducteurs électriques supplémentaires (24) sont réalisés en en métal ou en alliage métallique.

## Patentansprüche

1. Festköper-Digitaldetektor einer einfallenden Strahlung (11), wobei der Detektor (10) einen lichtempfindlichen Sensor (13), welcher in einer Matrix organisierte lichtempfindliche Elemente (16) beinhaltet, einen Lichtgenerator (14) beinhaltet, welcher dazu bestimmt ist die lichtempfindlichen Elemente (16) optisch zu löschen, wobei der Lichtgenerator (14) folgendes beinhaltet:
• eine auf der Oberfläche des Sensors (13) verteilte elektrolumineszente Schicht (21),
• mindestens eine Elektrode (22, 23), welche durchgängig die elektrolumineszente Schicht (21) bedeckt, wobei die Elektrode (22, 23) ein elektrischer Leiter ist, in welchem Elektronen frei zirkulieren können, wobei die Elektrode (22, 23) in der Lage ist, durch das durch die elektrolumineszente Schicht (21) abgegebene Licht durchquert zu werden,
wobei der Lichtgenerator **dadurch gekennzeichnet ist, dass** er zusätzliche elektrische Leiter (24, 36) in elektrischem Kontakt mit der Elektrode (22, 23) beinhaltet, wobei die zusätzlichen elektrischen Leiter (24, 36) Äste bilden, welche sich über die Oberfläche der Elektrode (22, 23) erstrecken und räumlich an der Oberfläche der Elektrode (22, 23) verteilt sind.

2. Detektor nach Anspruch 1, **dadurch gekennzeichnet, dass** die lichtempfindlichen Elemente (16) periodisch an der Oberfläche des Sensors (14) verteilt sind.

3. Detektor nach Anspruch 2, **dadurch gekennzeichnet, dass** die Verteilung der zusätzlichen elektrischen Leiter (24) periodisch und ein Vielfaches derjenigen der lichtempfindlichen Elemente (16) ist.

4. Detektor nach einem der vorhergehenden Ansprüche, **dadurch gekennzeichnet, dass** die zusätzlichen elektrischen Leiter eine erste Reihe zueinander paralleler Äste (24a) und eine zweite Reihe zueinander paralleler Äste (24b) beinhalten, und dass die erste Reihe (24a) und die zweite Reihe (24b) einander kreuzen.

5. Detektor nach einem der vorhergehenden Ansprüche, **dadurch gekennzeichnet, dass** er einen Szintillator (12) beinhaltet, welcher die einfallende Strahlung, welche eine erste Strahlung (11) ist, in eine zweite Strahlung konvertiert, für welche der lichtempfindliche Sensor (13) empfindlich ist.

6. Detektor nach einem der Ansprüche 1 bis 4, **dadurch gekennzeichnet, dass** der lichtempfindliche Sensor (13) einen direkt für die einfallende Strahlung (11) empfindlichen Fotoleiter beinhaltet.

7. Detektor nach einem der vorhergehenden Ansprüche, **dadurch gekennzeichnet, dass** die zusätzlichen elektrischen Leiter (24) für das durch den Lichtgenerator (14) abgegebene Licht undurchlässig sind.

8. Detektor nach einem der vorhergehenden Ansprüche, **dadurch gekennzeichnet, dass** der Lichtgenerator (14) im vorgelagerten Bereich des lichtempfindlichen Sensors (13) in der Fortpflanzungsrichtung der ersten Strahlung (11) angeordnet ist, dass Zwischenräume (31) zwischen benachbarten lichtempfindlichen Elementen (16) gebildet sind und dass die zusätzlichen elektrischen Leiter (24) gegenüber den Zwischenräumen (31) angeordnet sind, welche die lichtempfindlichen Elemente (16) trennen.

9. Detektor nach Anspruch 8, **dadurch gekennzeichnet, dass** die zusätzlichen elektrischen Leiter (24) die lichtempfindlichen Elemente (16) nicht bedecken.

10. Detektor nach Anspruch 5 und einem der Ansprüche 8 oder 9, **dadurch gekennzeichnet, dass** der Lichtgenerator (14) zwischen dem Szintillator (12) und dem lichtempfindlichen Sensor (13) angeordnet ist.

11. Detektor nach Anspruch 10, **dadurch gekennzeichnet, dass** er eine Passivierungsschicht (34) beinhaltet, welche zwischen dem lichtempfindlichen Sensor (13) und dem Lichtgenerator (14) angeordnet ist.

12. Detektor nach Anspruch 5 und einem der Ansprüche 7 bis 9, **dadurch gekennzeichnet, dass** der Lichtgenerator (14) im vorgelagerten Bereich des Szintillators (12) in der Fortpflanzungsrichtung der ersten Strahlung (11) angeordnet ist.

13. Detektor nach einem der Ansprüche 5 bis 7, **dadurch gekennzeichnet, dass** der Lichtgenerator (14) im nachgelagerten Bereich des lichtempfindlichen Sensors (13) in der Fortpflanzungsrichtung der ersten Strahlung (11) angeordnet ist.

14. Detektor nach Anspruch 13, **dadurch gekennzeichnet, dass** der lichtempfindliche Sensor (13) ein Substrat (15) beinhaltet, auf welchem die lichtempfindlichen Elemente (16) angeordnet sind, dass der Lichtgenerator (14) im nachgelagerten Bereich des Substrates (15) angeordnet ist und dass das Substrat (15) in der Lage ist, durch das durch den Lichtgenerator (14) abgegebene Licht durchquert zu werden.

15. Detektor nach einem der vorhergehenden Ansprüche, **dadurch gekennzeichnet, dass** die elektrolumineszente Schicht (21) auf Höhe der zusätzlichen elektrischen Leiter (24, 36) unterbrochen ist.

16. Detektor nach einem der vorhergehenden Ansprüche, **dadurch gekennzeichnet, dass** die zusätzlichen elektrischen Leiter (24) aus Metall oder einer metallischen Legierung gefertigt sind.

## Claims

1. A solid-state digital detector for detecting incident radiation (11), the detector (10) comprising a photosensitive sensor (13) comprising photosensitive elements (16) that are organized in a matrix, a light generator (14) whose purpose is to optically wipe the photosensitive elements (16), the light generator (14) comprising:
• an electroluminescent layer (21) that is distributed over the surface of the sensor (13);
• at least one electrode (22, 23) that continuously covers the electroluminescent layer (21), the electrode (22, 23) being an electrical conductor in which electrons may flow freely, the electrode (22, 23) being capable of being passed through by the light emitted by the electroluminescent layer (21);
the light generator being **characterized in that** it comprises additional electrical conductors (24, 36) that are in electrical contact with the electrode (22, 23), the additional electrical conductors (24, 36) forming branches that extend over the surface of the electrode (22, 23), and being spatially distributed across the surface of the electrode (22, 23).

2. The detector as claimed in claim 1, **characterized in that** the photosensitive elements (16) are periodically distributed on the surface of the sensor (14).

3. The detector as claimed in claim 2, **characterized in that** the distribution of the additional electrical conductors (24) is periodic and multiple of that of the photosensitive elements (16).

4. The detector as claimed in one of the preceding claims, **characterized in that** the additional electrical conductors comprise a first series of mutually parallel branches (24a) and a second series of mutually parallel branches (24b) and **in that** the first series (24a) and the second series (24b) intersect.

5. The detector as claimed in one of the preceding claims, **characterized in that** it comprises a scintillator (12) that converts the incident radiation, being a first radiation (11), to a second radiation to which the photosensitive sensor (13) is sensitive.

6. The detector as claimed in one of claims 1 to 4, **characterized in that** the photosensitive sensor (13) comprises a photoconductor that is directly sensitive to the incident radiation (11).

7. The detector as claimed in one of the preceding claims, **characterized in that** the additional electrical conductors (24) are opaque to the light emitted by the light generator (14).

8. The detector as claimed in one of the preceding claims, **characterized in that** the light generator (14) is positioned upstream of the photosensitive sensor (13) in the direction of propagation of the first radiation (11), **in that** interstices (31) are formed between neighbouring photosensitive elements (16) and **in that** the additional electrical conductors (24) are positioned facing interstices (31) that separate the photosensitive elements (16).

9. The detector as claimed in claim 8, **characterized in that** the additional electrical conductors (24) do not overlap the photosensitive elements (16).

10. The detector as claimed in claim 5 and either of claims 8 and 9, **characterized in that** the light generator (14) is positioned between the scintillator (12) and the photosensitive sensor (13).

11. The detector as claimed in claim 10, **characterized in that** it comprises a passivation layer (34) that is positioned between the photosensitive sensor (13) and the light generator (14).

12. The detector as claimed in claim 5 and any one of claims 7 to 9, **characterized in that** the light generator (14) is positioned upstream of the scintillator (12) in the direction of propagation of the first radiation (11).

13. The detector as claimed in any one of claims 5 to 7, **characterized in that** the light generator (14) is positioned downstream of the photosensitive sensor (13) in the direction of propagation of the first radiation (11).

14. The detector as claimed in claim 13, **characterized in that** the photosensitive sensor (13) comprises a substrate (15) on which the photosensitive elements (16) are positioned, **in that** the light generator (14) is positioned downstream of the substrate (15) and **in that** the substrate (15) is capable of being passed through by the light emitted by the light generator (14).

15. The detector as claimed in one of the preceding claims, **characterized in that** the electroluminescent layer (21) is interrupted at the level of the additional electrical conductors (24, 36).

16. The detector as claimed in one of the preceding claims, **characterized in that** the additional electrical conductors (24) are made of metal or metal alloy.
